# EUROPÄISCHE PATENTSCHRIFT

(11) **EP 3 646 048 B1**
(45) Veröffentlichungstag und Bekanntmachung des Hinweises auf die Patenterteilung: **02.03.2022**
(21) Anmeldenummer: 18727716.5
(22) Anmeldetag: 16.05.2018
(51) Int. Cl.: G01R 33/46, G01N 24/08, G01R 33/38

(54) **VERFAHREN ZUM AUTOMATISIERTEN QUANTIFIZIEREN EINES ANALYTEN SOWIE NMR-MESSGERÄT ZUR DURCHFÜHRUNG DES VERFAHRENS**
METHOD FOR AUTOMATICALLY QUANTIFYING AN ANALYTE, AND NMR MEASURING DEVICE FOR CARRYING OUT THE METHOD
PROCÉDÉ DE QUANTIFICATION AUTOMATISÉE D'UN ANALYTE ET APPAREIL DE MESURE À RMN DESTINÉ À LA MISE EN OEUVRE DU PROCÉDÉ

(30) Priorität: 26.06.2017 DE 102017210700
(43) Veröffentlichungstag der Anmeldung: 06.05.2020
(73) Patentinhaber: Robert Bosch GmbH, 70442 Stuttgart (DE)
(72) Erfinder: HAUSLER, Thomas, 82362 Weilheim In Oberbayern (DE)
(86) Internationale Anmeldenummer: PCT/EP2018/062715
(87) Internationale Veröffentlichungsnummer: WO 2019/001835

(56) Entgegenhaltungen:
- JP-A- 2000 147 081
- US-A1- 2014 343 873
- JIE HAO ET AL: "Bayesian deconvolution and quantification of metabolites in complex 1D NMR spectra using BATMAN", NATURE PROTOCOLS, Bd. 9, Nr. 6, 22. Mai 2014 (2014-05-22), Seiten 1416-1427, XP055333942, GB ISSN: 1754-2189, DOI: 10.1038/nprot.2014.090
- AUDREY TARDIEU ET AL: "Using one-dimensional (1D) and two-dimensional (2D) quantitative proton (1H) nuclear magnetic resonance spectroscopy (q NMR) for the identification and quantification of taste compounds in raw onion (Allium cepa L.) bulbs and in aqueous solutions where onion tissues are soaked", ANALYTICAL AND BIOANALYTICAL CHEMISTRY, Bd. 398, Nr. 7-8, 23. Oktober 2010 (2010-10-23), Seiten 3139-3153, XP055499463, DE ISSN: 1618-2642, DOI: 10.1007/s00216-010-4255-x
- XIA JIANGUO ET AL: "MetaboMiner - semi-automated identification of metabolites from 2D NMR spectra of complex biofluids", BMC BIOINFORMATICS, BIOMED CENTRAL, LONDON, GB, Bd. 9, Nr. 1, 28. November 2008 (2008-11-28), Seite 507, XP021041863, ISSN: 1471-2105, DOI: 10.1186/1471-2105-9-507
- BAEK H.-M. ET AL.: "2-Hydroxyglutarate in Gliomas with IDH Gene Mutation Using High Resolution 1H-NMR Spectroscopy of Tissue Extracts", PROCEEDINGS OF THE INTERNATIONAL SOCIETY FOR MAGNETIC RESONANCE IN MEDICINE, 20TH ANNUAL MEETING, 5. Mai 2012 (2012-05-05), Seite 845, XP040623269, Melbourne, Australia

## Beschreibung

### Stand der Technik

Die vorliegende Erfindung betrifft ein Verfahren zum automatisierten Quantifizieren eines Analyten sowie ein NMR-Messgerät mit einem Kernspinresonanz-Sensor, insbesondere ein mobiles, bevorzugt handgehaltenes NMR-Messgerät, zur Durchführung des Verfahrens.

Verfahren zur Quantifizierung von Analyten, insbesondere in Flüssigkeiten, gibt es in großer Anzahl, beispielsweise in Form von Trennverfahren wie Gaschromatographie (GC) oder Hochleistungs-Flüssigkeitschromatographie (HPLC), Titration oder dergleichen. Allerdings gehen derartige Methoden mit hohem Präparationsaufwand und hohem Verbrauch an Lösungsmitteln einher. Infrarot-Spektroskopie erlaubt es, mit geringem Aufwand eine Vielzahl von Substanzen in einer Probe zu erfassen. Allerdings ist auf Grund ausgeprägter Überlagerung der Signale eine Quantifizierung nur indirekt und verhältnismäßig unpräzise möglich. Ferner spielen in der Infrarot-Spektroskopie Matrixeffekte eine entscheidende Rolle, sodass die zu erfassenden Konzentrationsbereiche oftmals nicht ausreichen, um Analyten in unterschiedlichen Flüssigkeiten exakt quantifizieren zu können.

Die Quantifizierung von Analyten in Flüssigkeiten mit Hilfe von Kernspinresonanzverfahren (im Folgenden kurz: NMR) ist bereits Stand der Technik. Jie Hao et al. ("Bayesian deconvolution and quantification of metabolites in complex 1D NMR spectra using BATMAN", NATURE PROTOCOLS, 2014) offenbart ein Verfahren zum automatisierten Quantifizieren eines Analyten unter Verwendung von 1D- und 2D-Spektren. Audrey Tardieu et al. ("Using one-dimensional and two-dimensional quantitative proton nuclear magnetic resonance spectroscopy for the identification and quantification of taste compounds in raw onion bulbs and in aqueous solutions where onion tissues are soaked", ANALYTICAL AND BIOANALYTICAL CHEMISTRY, 2010) offenbart ein Verfahren zur automatisierten Quantifizierung eines Analyten in einer flüssigen Messprobe sowie die Verwendung von 2D COSY-Spektren zum Zwecke einer genauen Peak-Zuordnung. Ferner offenbart DE 10 2014 203 721 A1 ein Verfahren zur

Bestimmung der Konzentration einer Substanz in einer Probe mittels Kernspinresonanz-Spektroskopie.

Aus DE 10 2014 218 375 A1 und DE 10 2014 218 371 A1 sind mobile NMR-Messgeräte mit jeweils einer Sensorvorrichtung bekannt, wobei die Sensorvorrichtung zumindest einen Kernspinresonanz-Sensor (NMR-Sensor) aufweist, der zur Bestimmung eines Feuchtewerts bzw. zur Detektion und/oder Analyse und/oder Unterscheidung von Materialkennwerten eines zu untersuchenden Werkstücks vorgesehen ist.

### Offenbarung der Erfindung

Es wird ein Verfahren zum automatisierten Quantifizieren eines Analyten in einer Messprobe, insbesondere in einer flüssigen Messprobe, insbesondere mittels eines NMR-Messgeräts, vorgeschlagen. Das erfindungsgemäße Verfahren enthält zumindest folgende Verfahrensschritte:
- Spezifizieren eines zu quantifizierenden Analyten;
- Bereitstellen eines, insbesondere mittels eines NMR-Sensors des NMR-Messgeräts gemessenen, 1D-NMR-Spektrums;
- Bereitstellen eines, insbesondere mittels eines NMR-Sensors des NMR-Messgeräts gemessenen, 2D-NMR-Spektrums, insbesondere eines JRES-, HMBC-, HSQC-, COSY- und/oder DOSY-Spektrums;
- Bereitstellen einer Information zu einem zu quantifizierenden Analyten;
- Ermitteln einer chemischen Verschiebung (d.h. der exakten Frequenz im fouriertransformierten Spektrum) eines NMR-Signals des zu quantifizierenden Analyten aus dem 2D-NMR-Spektrum unter Verwendung der zumindest einen bereitgestellten Information;
- Ermitteln von erwarteten Peak-Positionen (d.h. insbesondere Frequenz-Werten im fouriertransformierten Spektrum) des NMR-Signals des zu quantifizierenden Analyten, insbesondere eines Singulets und/oder Multiplets des zu quantifizierenden Analyten;
- Ermitteln von tatsächlichen Peak-Positionen aus dem 1D-NMR-Spektrum;
- Ermitteln von Störsignal-Peak-Positionen unter Verwendung der erwarteten Peak-Positionen und der tatsächlichen Peak-Positionen;
- Modellieren des 1D-NMR-Spektrums unter Verwendung der ermittelten Störsignal-Peak-Positionen, unter Verwendung der ermittelten chemischen Verschiebung sowie unter Verwendung der zumindest einen bereitgestellten Information;
- Integration des modellierten, insbesondere Störsignal-Peak-bereinigten, 1D-NMR-Spektrums;
- Quantifizieren des Analyten durch interne oder externe Referenzierung.

In einer Ausführungsform des Verfahrens können die Verfahrensschritte in der dargestellten Reihenfolge durchgeführt werden. Alternativ kann die Reihenfolge der in erfindungsgemäßem Verfahren durchgeführten Verfahrensschritte auch von der zuvor dargestellten Reihenfolge abweichen.

In einer Ausführungsform des Verfahrens ist das Verfahren dazu vorgesehen, von einem NMR-Messgerät bzw. unter Verwendung eines NMR-Messgeräts ausgeführt zu werden. Ein entsprechendes NMR-Messgerät, insbesondere ein mobiles, bevorzugt handgehaltenes, NMR-Messgerät, weist dazu zumindest einen NMR-Sensor (die Begriffe "Kernspinresonanz-Sensor" und "NMR-Sensor" werden in dieser Schrift synonym verwendet), eine Steuervorrichtung zur Steuerung des NMR-Messgeräts und zur Auswertung eines von dem Kernspinresonanz-Sensor gelieferten Messsignals, eine Ausgabevorrichtung zur Ausgabe von ermittelten Informationen sowie eine Energieversorgungsvorrichtung, insbesondere eine Batterie, auf. Ferner ist das NMR-Messgerät, insbesondere dessen Steuervorrichtung, zur Durchführung des erfindungsgemäßen Verfahrens vorgesehen und eingerichtet.

Unter einem "handgehaltenen NMR-Messgerät" soll hier insbesondere verstanden werden, dass das NMR-Messgerät ohne Zuhilfenahme einer Transportmaschine lediglich mit den Händen, insbesondere mit einer Hand, transportiert und insbesondere auch während eines Messvorgangs an ein und/oder entlang einer zu untersuchenden Messprobe geführt werden kann. Dazu beträgt die Masse des handgehaltenen Messgeräts insbesondere weniger als 20 kg, vorteilhaft weniger als 10 kg und besonders vorteilhaft weniger als 2 kg.

In einer Ausführungsform eines handgehaltenen NMR-Messgeräts sind die Komponenten des NMR-Messgeräts, insbesondere der NMR-Sensor, die Steuervorrichtung sowie die Energieversorgungsvorrichtung des NMR-Messgeräts, zumindest teilweise in einem Gehäuse des NMR-Messgeräts untergebracht. Insbesondere sind die Komponenten in ihrem Gesamtvolumen zu mehr als 50 %, bevorzugt zu mehr als 75 % und besonders bevorzugt zu 100 % in dem Gehäuse des NMR-Messgeräts untergebracht.

In einer Ausführungsform ist das NMR-Messgerät als ein energieautonomes NMR-Messgerät realisiert. Unter "energieautonom" ist zu verstehen, dass das NMR-Messgerät zumindest vorübergehend, bevorzugt zumindest während der Durchführung einer Messung sowie einer Auswertung, unabhängig von einem Stromnetz, d.h. insbesondere kabellos, betrieben werden kann. Dazu weist das NMR-Messgerät eine Energieversorgungsvorrichtung in Form eines stromnetzunabhängigen Energiespeichers, insbesondere in Form einer Batterie, bevorzugt in Form einer wiederaufladbaren Batterie, auf. Die Energieversorgungsvorrichtung ist dazu vorgesehen, das NMR-Messgerät zur Inbetriebnahme und während des Betriebs mit elektrischer Energie zu versorgen. Der stromnetzunabhängige Energiespeicher kann in einer Ausführungsform als eine Brennstoffzelle, ein Kondensator, ein hybrider Superkondensator oder als ein anderweitiger, dem Fachmann sinnvoll erscheinender Energiespeicher oder eine Kombination/Mehrung derer realisiert sein. Insbesondere eignen sich zur Energieversorgung des NMR-Messgeräts Akkumulatoren mit einer Zellchemie, die eine hohe Leistungs- und/oder Energiedichte bereitstellt. Eine hohe Leistungs- und/oder Energiedichte erlaubt eine verbesserte, d.h. langlebigere und an einen hohen Leistungsbedarf des NMR-Sensors angepasste, Energieversorgung des NMR-Messgeräts. Dazu gehören derzeit beispielsweise Akkumulatoren der Lithium- und Lithium-Ionen-Zellchemie, insbesondere Lithium-Eisenphosphat-, Lithium-Manganoxid-, Lithium-Nickel-Cobalt-Mangan-Oxid-, überlithiierte Lithium-Nickel-Cobalt-Mangan-Oxid-, Lithium-Schwefel-, Lithium-Polymer- und Lithium-Sauerstoff-Akkumulatoren.

Unter "vorgesehen" soll insbesondere speziell "programmiert", "ausgelegt" und/oder "ausgestattet" verstanden werden. Darunter, dass ein Objekt zu einer bestimmten Funktion "vorgesehen" ist, soll insbesondere verstanden werden, dass das Objekt diese bestimmte Funktion in zumindest einem Anwendungs- und/oder Betriebszustand erfüllt und/oder ausführt oder dazu ausgelegt ist, die Funktion zu erfüllen.

Das erfindungsgemäße NMR-Messgerät weist eine Steuervorrichtung zu dessen Steuerung auf. Die Steuervorrichtung ist mit den anderen Komponenten des NMR-Messgeräts, insbesondere dem NMR-Sensor, der Ausgabevorrichtung, der Energieversorgungsvorrichtung, ferner beispielsweise einer Eingabevorrichtung und/oder einer Datenkommunikationsschnittstelle, signaltechnisch verbunden. Die Steuervorrichtung ist dazu vorgesehen, während des Betriebs des NMR-Messgeräts mit diesen Komponenten zu kommunizieren. Unter der "Steuervorrichtung" soll insbesondere eine Vorrichtung mit zumindest einer Steuerelektronik verstanden werden, die Mittel zur Kommunikation mit den anderen Komponenten des NMR-Messgeräts, beispielsweise Mittel zur Steuerung und/oder Regelung des NMR-Sensors, Mittel zur Datenverarbeitung, Mittel zur Datenspeicherung und/oder weitere, dem Fachmann als sinnvoll erscheinende Mittel aufweist. In einer Ausführungsform ist unter der Steuerelektronik der Steuervorrichtung eine Prozessoreinheit in Verbindung mit einer Speichereinheit sowie mit einem in der Speichereinheit gespeicherten Betriebsprogramm zu verstehen, das während des Steuervorgangs ausgeführt wird. Insbesondere können die elektronischen Bauteile der Steuervorrichtung auf einer Platine (Leiterplatte) angeordnet sein, beispielsweise in Form eines Mikrokontrollers. Die Steuervorrichtung dient ferner zur Auswertung zumindest eines von dem NMR-Sensor gelieferten Messsignals, insbesondere zur Auswertung eines von dem NMR-Sensor bereitgestellten 1D-NMR-Spektrums und eines von dem NMR-Sensor bereitgestellten 2D-NMR-Spektrums, insbesondere eines JRES-, HMBC-, HSQC-, COSY- und/oder DOSY-Spektrums. Alternativ oder zusätzlich kann das Messsignal, insbesondere ein 1D-NMR-Spektrum und ein 2D-NMR-Spektrum, insbesondere ein JRES-, HMBC-, HSQC-, COSY- und/oder DOSY-Spektrum, auch anderweitig der Steuervorrichtung bereitgestellt werden, beispielsweis unter Verwendung einer Datenkommunikationsschnittstelle des NMR-Messgeräts. "Zur Auswertung vorgesehen" bedeutet insbesondere, dass die Steuervorrichtung einen Informationseingang zur Annahme der Messsignale, insbesondere der Spektren, eine Informationsverarbeitungseinheit zur Bearbeitung, insbesondere Auswertung der Messsignale, insbesondere der Spektren, sowie eine Informationsausgabe zur Weitergabe der bearbeiteten und/oder ausgewerteten Messsignale, insbesondere der Spektren, und/oder erhaltener Auswerteergebnisse aufweist. In einer Ausführungsform weist die Steuervorrichtung dazu Komponenten auf, die zumindest einen Prozessor, einen Speicher und ein Betriebsprogramm mit Auswerte- und Berechnungsroutinen umfassen. Insbesondere können diese Komponenten auch als Auswertevorrichtung bezeichnet werden und/oder als zur Steuervorrichtung separate Auswertevorrichtung ausgeführt sein.

Unter einer "Ausgabevorrichtung" des NMR-Messgeräts soll zumindest ein Mittel verstanden werden, das dazu vorgesehen ist, zumindest eine wechselnde Information akustisch, optisch und/oder taktil an einen Bediener auszugeben. Die Ausgabevorrichtung dient der Ausgabe zumindest derjenigen Informationen an den Bediener des NMR-Messgeräts, die unter Verwendung des NMR-Messgeräts erhalten werden. Insbesondere kann mittels der Ausgabevorrichtung ein Ergebnis der Quantifizierung des Analyten ausgegeben werden. Die Ausgabe kann dabei beispielsweise mittels eines Bildschirms, eines berührungssensitiven Bildschirms, eines Tonsignals, eines Vibrationsgebers und/oder einer LED-Anzeige realisiert werden. In einer Ausführungsform der Ausgabevorrichtung kann die Information grafisch oder alphanumerisch als Messergebnis der Untersuchung ausgegeben werden. Die Ausgabevorrichtung ist in einer Ausführungsform im Gehäuse des handgehaltenen NMR-Messgeräts untergebracht. Ferner können auszugebende Informationen oder Ergebnisse auch an die Steuervorrichtung und/oder, insbesondere zur Erhöhung des Nutzerkomforts, an ein Daten verarbeitendes System ausgegeben werden. Letzteres umfasst zumindest eine Ausgabe einer Information an ein externes Geräte wie ein Smartphone, ein Tablet-PC, ein PC sowie an ein anderes, einem Fachmann als sinnvoll erscheinendes externes Datengerät, das über eine Datenkommunikationsschnittstelle mit dem NMR-Messgerät verbunden ist. Insbesondere kann die Ausgabevorrichtung direkt im Gehäuse des NMR-Messgeräts untergebracht sein und kann zusätzlich auch über externe Ausgabevorrichtungen ergänzt werden. Unter Verwendung der mittels der Ausgabevorrichtung an einen Benutzer des NMR-Messgeräts ausgegeben Information ist es dem Benutzer des NMR-Messgeräts möglich, nach Durchführung der Quantifizierung des Analyten in der Messprobe zu einem intuitiv verständlichen Ergebnis zu gelangen.

Zur Durchführung von Messungen, insbesondere zum Messen eines 1D-NMR-Spektrums und eines 2D-NMR-Spektrums, insbesondere eines JRES-, HMBC-, HSQC-, COSY- und/oder DOSY-Spektrums, weist das NMR-Messgerät zumindest einen NMR-Sensor auf. Die Funktionsweise des NMR-Sensors basiert auf dem kernphysikalischen Effekt, bei dem Atomkerne in der zu untersuchenden Messprobe in einem ersten Magnetfeld, bezeichnet mit B₀, elektromagnetische Wechselfelder absorbieren und emittieren. Dabei beruht die Kernspinresonanz auf der Präzession (Larmorpräzession) von Kernspins der Atomkerne in der zu untersuchenden Messprobe um die Magnetfeldlinien des ersten, insbesondere konstanten und/oder statischen, Magnetfelds. Insbesondere werden die Kernspins der Atomkerne in einem zu untersuchenden Volumen durch das erste Magnetfeld ausgerichtet. Wird Energie in Form eines zweiten elektromagnetischen Feldes, insbesondere eines Wechselfeldes, beispielsweise eines gepulsten Magnetfeldes, auf die Atomkerne eingestrahlt, die mit der Larmorpräzession deren Kernspins in Resonanz ist (Energiequanten), so können die Atomkerne die Orientierung ihrer Spins relativ zum ersten Magnetfeld durch Absorption dieser Energie ändern. Das zweite eingestrahlte Magnetfeld dient daher der Anregung der Kernspins, die unter Energieaufnahme ihre Kernspinzustände ändern. Äquivalent führt die Emission von Energiequanten in Folge einer Rückkehr der angeregten Kernspins in ein anderes, niedrigeres Energieniveau, zur Emission eines elektromagnetischen Wechselfeldes, welches sich mittels einer Vorrichtung zur Detektion einer Magnetfeldänderung, insbesondere mittels einer Antenne und/oder einer Spule, beobachten lässt. Unter den Atomkernen sind insbesondere Protonen (H) und andere kernspinresonanz-aktive Kerne wie beispielsweise 13C, 15N, 19F, 31P zu verstehen.

Das erfindungsgemäße NMR-Messgerät erlaubt aus den von dem zumindest einen NMR-Sensor erhaltenen NMR-Spektren Informationen zu bestimmen und somit Aussagen abzuleiten, die die Eigenschaften und insbesondere den Zustand einer Messprobe und insbesondere die Konzentration von darin enthaltenen Analyten betreffen. Beispielsweise lassen sich bei geeigneter Auswertung der NMR-Spektren Informationen ermitteln hinsichtlich einer Qualität (beispielsweise von Getränken oder von Kraftstoffen oder von Körperflüssigkeiten), hinsichtlich eines Vorhandenseins von Inhaltsstoffen (z.B. gesundheitsschädliche Inhaltsstoffe, verbotene Inhaltsstoffe, Pestizide, Fungizide, Hormone, Antibiotika) oder dergleichen. Aus diesen ausgewerteten Informationen kann ein Bediener des NMR-Messgeräts somit Eigenschaften wie Qualität, Herkunft, Echtheit, Zusammensetzung, Gefahrenpotential oder dergleichen von untersuchten Messproben auf einfache Weise untersuchen und überprüfen. Ferner lassen sich die erhaltenen Informationen mit Herstellerangaben vergleichen und somit die Authentizität der Herstellerangaben prüfen.

Zur Durchführung der Messung wird das mobile NMR-Messgerät, insbesondere der zumindest eine NMR-Sensor, nahe an die zu untersuchende Messprobe herangebracht oder umgekehrt. Die Verwendung des Messgeräts erlaubt dabei die Untersuchung der Messprobe ohne Beeinträchtigung, insbesondere ohne Zerstörung, Kontamination oder dergleichen.

Das mobile, energieautonome NMR-Messgerät stellt ein spezialisiertes Messgerät dar, das im Vergleich zu wissenschaftlichen Kernspinresonanz-Messgeräten eine stark eingeschränkte, auf die Untersuchung einer Messprobe optimierte Funktionalität aufweist. Insbesondere die Steuervorrichtung mit ihren Auswerteroutinen ist auf die Durchführung des erfindungsgemäßen Verfahrens zugeschnitten. Ferner kann das NMR-Messgerät auf die Bewertung der erhaltenen Informationen sowie deren aufbereiteter Darstellung und Ausgabe mittels einer Ausgabevorrichtung zugeschnitten sein. Bei Verwendung des Messgeräts zur Untersuchung einer Messprobe werden die Messergebnisse für den Bediener des NMR-Messgeräts geräteintern und der Messung unmittelbar folgend aufbereitet, sodass eine schnelle, eindeutige und vor allem von weiteren Geräten wie Computern oder gar von Laboratorien unabhängige Quantifizierung eines Analyten in der Messprobe vor Ort möglich ist. Vorteilhaft ist eine einfache und intuitive Bedienung des Messgeräts erreichbar, die keine besondere Vorerfahrung des Bedieners voraussetzt.

Durch Verwendung des handgehaltenen, energieautonomen und speziell auf den Anwendungsfall der Untersuchung einer Messprobe zugeschnittenen Messgeräts ist es möglich, auf schnelle und zerstörungsfreie Weise und damit wirtschaftlich besonders kostengünstig eine präzise und umfassende Quantifizierung eines Analyten in einer Messprobe mobil vor Ort, beispielsweise in einem Lagerhaus, einem Einkaufsladen, auf einem Großhandel, bei einem Patientenbesuch oder dergleichen, zu realisieren.

Unter "Quantifizieren eines Analyten in einer Messprobe" ist insbesondere die Bestimmung einer Konzentration einer Substanz, d.h. eines Analyten, in der Messprobe, insbesondere einer flüssigen Messprobe, zu verstehen. In der NMR-Spektroskopie liefert jeder Analyt ein oder mehrere charakteristische, frequenzabhängige Signale (NMR-Signal). Die integrierte Intensität der von einem bestimmten Analyten hervorgerufenen Peaks in einem 1D-NMR-Spektrum ist grundsätzlich proportional zur Konzentration des zugehörigen Analyten in der Probe. Da jedes Proton einen definierten Beitrag zum 1D-NMR-Spektrum liefert, ist eine direkte, exakte Quantifizierung möglich. Allerdings ist es aufgrund der Überlagerung einer Vielzahl von Peaks in einem 1D-NMR-Spektrum oft nicht einfach, den Signalanteil, der zu einer bestimmten Substanz gehört, quantitativ zu bestimmen. Sind mehrere unterschiedliche Analyten in der Messprobe vorhanden, deren NMR-Signale sich überlagern, so kann es dennoch durch die Technik des "Line-Fittings" möglich sein, ein Signalensemble durch einzelne Signale auszudrücken. Auf diese Weise kann somit eine Quantifizierung auch im Falle einer Überlagerung diverser Signale möglich sein.

Unter "NMR-Signal" ist in dieser Schrift das von einer Aufbereitung (beispielsweise einer Fouriertransformation) unabhängige, physikalische Signal der Messprobe während einer NMR-Messung zu verstehen, dass sich lediglich als Resultat der chemischen Struktur in der Messprobe ergibt.

In einer Ausführungsform des Verfahrens wird der zumindest eine zu quantifizierenden Analyt in einem weiteren Verfahrensschritt spezifiziert. Auf diese Weise kann der zu quantifizierende Analyt von einem Anwender des erfindungsgemäßen Verfahrens entsprechend seines Interesses ausgewählt werden. Insbesondere kann der zumindest eine zu quantifizierenden Analyt in Folge einer Eingabe oder Auswahl durch einen Benutzer, beispielsweise mittels einer Eingabevorrichtung oder mittels einer Menüauswahl oder mittels eines Bar-Code-Scanners (beispielsweise durch Einscannen eines produktspezifischen Bar-Codes) oder dergleichen, spezifiziert werden. Alternativ kann diese Information auch der Recheneinheit bzw. der Steuervorrichtung anderweitig bereitgestellt werden, beispielsweise durch Auslesen eines Speichers. In einer Ausführungsform ist die Information zu dem zumindest einen zu quantifizierenden Analyten eine statische Information, d.h. in erfindungsgemäßem Verfahren wird stets der gleiche Analyt quantifiziert.

Durch die Spezifizierung des zumindest einen zu analysierenden Analyten lassen sich eine Informationsverarbeitung, insbesondere die Auswertung der Spektren oder dergleichen, vorteilhaft an den zu untersuchenden Analyten anpassen. Beispielsweise kann in Abhängigkeit der Spezifizierung eine Referenzdatenbank gewählt werden. Ferner können insbesondere im Zusammenhang mit der Spezifikation ein Betriebsprogramm der Steuervorrichtung, Regelroutinen, Steuerroutinen, Auswerteroutinen und/oder Berechnungsroutinen angepasst werden.

In einem Verfahrensschritt des erfindungsgemäßen Verfahrens wird ein 1D-NMR-Spektrum bereitgestellt. Unter "bereitstellen" ist im Folgenden insbesondere zu verstehen, dass der Recheneinheit, die das erfindungsgemäße Verfahren durchführt, insbesondere der Steuervorrichtung des NMR-Messgeräts, eine entsprechende Information oder ein Datensatz bereitgestellt wird. Ein derartiges 1D-NMR-Spektrum wird typischerweise erhalten, wenn die in einem Analyten enthaltenen Kernspins in einem starken, statischen magnetischen Feld ausgerichtet und mit einem Hochfrequenz-Puls energetisch angeregt (d.h. die Kernmagnetisierung wird gedreht) werden. Anschließend wird die Hochfrequenz-Antwort der Probe als Funktion der Zeit aufgezeichnet und derart ein FID-Signal (free-induction-decay-Signal) erhalten. Durch Fourier-Transformation kann aus dem FID-Signal ein Frequenzspektrum der Probe erhalten werden, in welchem für die einzelnen Bestandteile der Probe charakteristische Peaks enthalten sind, wobei die einzelnen Peaks der Bestandteile mehr oder weniger stark überlagern.

In einer Ausführungsform des Verfahrens wird der Analyt unter Anwendung einer 1H-NMR-Spektroskopie quantifiziert. Mit der 1H-NMR-Spektroskopie werden dabei alle Substanzen erfasst, welche ein nicht austauschbares Proton besitzen, beispielsweise Zucker, Alkohole, organische Säuren und Ester, aromatische Stoffe wie Anilin oder Vanillin, oder dergleichen. In einer Ausführungsform des Verfahrens wird ein 1H-NMR-Spektrum ohne Unterdrückung von Frequenzen bereitgestellt, um Hauptkomponenten wie Wasser und/oder Alkohole quantifizieren zu können. Alternativ wird ein 1H-NMR-Spektrum mit selektiver Signalunterdrückung, insbesondere mit Lösungsmittelunterdrückung, bereitgestellt, um Analyten in sehr geringen Konzentrationen quantifizieren zu können.

Ferner wird in einem Verfahrensschritt des erfindungsgemäßen Verfahrens ein 2D-NMR-Spektrum, insbesondere ein JRES-, HMBC-, HSQC-, COSY- und/oder DOSY-Spektrum, bereitgestellt. Ein derartiges 2D-NMR-Spektrum wird typischerweise erhalten, wenn die in einem Analyten enthaltenen Kernspins in einem starken, statischen magnetischen Feld ausgerichtet und mit einem Hochfrequenz-Puls energetisch angeregt werden. Durch eine, für das jeweilige 2D-NMR-Spektrum typische, Pulsreihenfolge mit definierten Wartezeiten zwischen einzelnen Hochfrequenz-Pulsen, wird ein Magnetisierungsaustausch zwischen zwei oder mehreren Kernspin-aktiven Kernen erzeugt. Die Hochfrequenz-Antwort der Probe wird als Funktion der Zeit aufgezeichnet und derart ein FID-Signal erhalten. Durch Fourier-Transformation, insbesondere zweifache Fourier-Transformation, kann aus dem FID-Signal ein 2D-Frequenzspektrum der Probe erhalten werden, in welchem für die einzelnen Bestandteile der Probe charakteristische Peaks enthalten sind.

Das 2D-NMR-Spektrum, z. B. ein JRES-Spektrum, dient in erfindungsgemäßem Verfahren dazu, eine Kopplungskonstante und eine chemische Verschiebung von Peaks des Analyten in den bereitgestellten NMR-Signalen, insbesondere im bereitgestellten 1D-NMR-Spektrum, genau bestimmen zu können. Insbesondere ist auch die Verwendung von heteronuklearen 2D-NMR-Spektren wie beispielsweise HMBC oder HSQC für die eindeutige Zuordnung der Peaks möglich. Hierbei wird die Information über Verknüpfungen mit heteronuklearen Kernen wie 13C benutzt.

Insbesondere können diese Spektren, d.h. das 1D-NMR-Spektrum sowie das 2D-NMR-Spektrum, einer Recheneinheit bereitgestellt werden, die das erfindungsgemäße Verfahren durchführt. In einer Ausführungsform können diese Spektren einer Steuervorrichtung des erfindungsgemäßen NMR-Messgeräts bereitgestellt werden. In einer Ausführungsform können diese Spektren mittels des zumindest einen NMR-Sensors des erfindungsgemäßen NMR-Messgeräts gemessenen werden und der Steuervorrichtung des NMR-Messgeräts bereitgestellt werden.

In einer Ausführungsform des Verfahrens werden das 1D-NMR-Spektrum und das 2D-NMR-Spektrum unter gleichen Messbedingungen erhalten, insbesondere mittels des NMR-Sensors des NMR-Messgeräts gemessen. Bei derart übereinstimmenden Messbedingungen kann eine besonders präzise und zuverlässige Quantifizierung durchgeführt werden, da Verfälschungen oder Abweichungen in den Spektren auf Grund unterschiedlicher Messbedingungen vermieden und somit ausgeschlossen werden können. Die übereinstimmenden Messbedingungen betreffen insbesondere eine Temperatur des Messprobe und/oder ein Lösungsmittel in der Messprobe und/oder die Magnetfeldstärke des statischen Magnetfelds bei der jeweiligen Messung.

In einer Ausführungsform des Verfahrens können die Spektren vor der Weiterverarbeitung durch bekannte Verfahren der Datenauswertung vorteilhaft aufbereitet werden. Beispielsweise kann das 1D-NMR-Spektrum - oder entsprechend das fouriertransformierte FID-Spektrum - vorab mit einer geeignet gewählten Exponentialfunktion multipliziert werden, um ein verbessertes Signalzu-Rausch-Verhältnis zu erhalten. Ferner ist es möglich, Fehler in der Symmetrie der Spektren, welche aufgrund von Homogenitätsfehlern und Phasenfehlern auftreten können, durch ein automatisch durchgeführtes, sogenanntes "Reference Deconvolution"-Verfahren zu reduzieren oder zu beheben. Auch kann im Rahmen des Verfahrens eine Phasenkorrektur und eine Hintergrundkorrektur (Grundlinien-Korrektur) automatisch erfolgen, ebenso wie das Prozessieren der Spektren im Rahmen von mathematischen Methoden wie Glätten, Filtern, Mitteln oder dergleichen.

In einem weiteren Verfahrensschritt des erfindungsgemäßen Verfahrens wird zumindest eine Information zu zumindest einem zu quantifizierenden Analyten bereitgestellt. Insbesondere kann diese Information einer Recheneinheit bereitgestellt werden, die das erfindungsgemäße Verfahren durchführt. Insbesondere kann diese Information der Steuervorrichtung des erfindungsgemäßen NMR-Messgeräts bereitgestellt werden. In einer Ausführungsform des Verfahrens spezifiziert die zumindest eine bereitgestellte Information einen chemischen Verschiebungsbereich, eine Anzahl auswertbarer Signale, eine Multiplizität auswertbarer Signale und/oder eine Kopplungskonstante auswertbarer Signale zu dem zumindest einen zu quantifizierenden Analyten. Auf diese Weise kann eine besonders einfache, umfassende und präzise Quantifizierung des Analyten erfolgen. Insbesondere kann die bereitgestellte Information zur einfachen, umfassenden und präzisen Auswertung des bereitgestellten 1D-NMR-Spektrums und/oder des bereitgestellten 2D-NMR-Spektrums verwendet werden. In einer Ausführungsform des erfindungsgemäßen Verfahrens kann die bereitgestellte Information ferner den chemischen Verschiebungsbereich der mit Protonen koppelnden Kohlenstoffkerne betreffen. Diese Information wird für die Identifizierung durch ein 2D-NMR-Spektrum und die Bestimmung der exakten chemischen Verschiebung verwendet.

Der "chemischen Verschiebungsbereich" gibt dabei den ungefähren Frequenzbereich an, in welchem das zu untersuchende Signal eines Analyten in dem bereitgestellten Spektrum zu erwarten ist.

Unter der "Anzahl auswertbarer Signale" ist die Anzahl der Signale zu verstehen, welche durch den Analyten im Spektrum hervorgerufen werden. Die Anzahl ist somit abhängig von der chemischen Struktur des Analyten. Insbesondere kann die Anzahl auswertbarer Signale durch Vorauswahl des zu quantifizierenden Analyten vorgegeben werden.

Die "Multiplizität" auswertbarer Signale kennzeichnet die Anzahl der Einzelsignale, welche ein auswertbares Signal als Gesamtsignal ergeben. Die Aufspaltung des Gesamtsignals in Einzelsignale wird durch Spin-Spin-Kopplung hervorgerufen. Die Multiplizität eines auswertbaren Signals ist abhängig von der chemischen Struktur des Analyten. Insbesondere kennzeichnet die "Multiplizität" die Anzahl der linear unabhängigen Zustände, die der Analyt hinsichtlich der Spin-Orientierung einnehmen kann, d.h. die sog. Spinmultiplizität. Die Multiplizität ist unmittelbar auf ein NMR-Spektrum übertragbar, in dem sich eine der Multiplizität entsprechende Anzahl von Peaks in dem Signal des Analyten ergeben.

Unter der "Kopplungskonstante auswertbarer Signale" ist eine Konstante zu verstehen, welche die Stärke der Wechselwirkung zweier koppelnder Kerne festlegt. Kopplungskonstanten sind charakteristisch für einen jeweiligen Analyten. Die Kopplungskonstante wird für die Identifizierung und für die Simulation/Modellierung der auswertbaren Signale durch einen Line-Fitting-Algorithmus verwendet.

In einer Ausführungsform des erfindungsgemäßen Verfahrens wird die zumindest eine Information zu dem zumindest einen zu quantifizierenden Analyten durch eine Datenbankabfrage bereitgestellt. Die zumindest eine Information kann dabei geräteintern in einer Datenbank auf einer Speichereinheit, insbesondere einer Speichereinheit einer Recheneinheit oder der Steuervorrichtung des NMR-Messgeräts, gespeichert sein. In einer alternativen oder zusätzlichen Ausführungsform kann die zumindest eine Information auch in einer externen, insbesondere geräteexternen, vorteilhaft stets aktuellen, Datenbank gespeichert sein. Beispielsweise kann die zumindest eine Information in einer Datenbank auf einem Computer, einem Server oder auf einem anderen, einem Fachmann sinnvoll erscheinenden Datenspeicher und/oder Datenverarbeitungsgerät gespeichert sein und von diesem bei Durchführung des erfindungsgemäßen Verfahrens bereitgestellt werden. Insbesondere kann die Bereitstellung der zumindest einen Information auch über einen Internetzugang des NMR-Messgeräts erfolgen. Alternativ oder zusätzlich kann die zumindest eine Information intern, insbesondere geräteintern in dem NMR-Messgerät, gespeichert sein und ebenfalls über einen Internetzugang des NMR-Messgeräts aktualisiert werden, beispielsweise durch einen Abgleich mit einer externen Referenzdatenbank.

In einem Verfahrensschritt wird eine chemische Verschiebung des NMR-Signals des zu quantifizierenden Analyten aus dem bereitgestellten 2D-NMR-Spektrum unter Verwendung der zumindest einen bereitgestellten Information ermittelt. Dazu wird die exakte Lage der Peaks, die zu dem zu quantifizierenden Analyten gehören, aus dem 2D-Spektrum, insbesondere dem JRES-Spektrum, bestimmt. Dabei wird in einer Ausführungsform des Verfahrens als Startwert der Auswertung ein für den Analyten typischer, d.h. vorbekannter, Verschiebungsbereich herangezogen. Bevorzugt wird dabei auf die den Verschiebungsbereich spezifizierende zumindest eine bereitgestellte Information zugegriffen. Auf diese Weise werden leichte Abweichungen in der chemischen Verschiebung toleriert. Ausgehend von den Startparametern wird das 2D-NMR-Spektrum auf Signale, d.h. Peaks, hin analysiert, welche den gegebenen Parametern, wie Kopplungskonstante, Multiplizität oder chemische Verschiebung der koppelnden 13C-Kerne, entsprechen. Bei Übereinstimmung eines Peaks mit den vorgegebenen Parametern aus der Datenbank wird die exakte chemische Verschiebung des Peaks bestimmt.

Ferner kann in diesem Verfahrensschritt auch eine Kopplungskonstante und eine Multiplizität des Analyten aus dem 2D-NMR-Spektrum, insbesondere aus dem JRES-Spektrum, ermittelt werden. Die ermittelte Kopplungskonstante und die ermittelte Multiplizität kann anschließend mit der zumindest einen bereitgestellte Information, die ebenfalls eine Kopplungskonstante und eine Multiplizität des Analyten betreffen kann, abgeglichen werden.

In einem Verfahrensschritt werden erwartete Peak-Positionen des NMR-Signals des zu quantifizierenden Analyten, insbesondere eines Singulets und/oder Multiplets des zu quantifizierenden Analyten, ermittelt. In einer Ausführungsform des Verfahrens werden die erwarteten Peak-Positionen des NMR-Signals des zu quantifizierenden Analyten, insbesondere eines Singulets und/oder Multiplets des zu quantifizierenden Analyten, unter Verwendung der ermittelten chemischen Verschiebung und der zumindest einen bereitgestellten Information, insbesondere einer bereitgestellten Multiplizität auswertbarer Signale und einer bereitgestellten Kopplungskonstante auswertbarer Signale, berechnet. Dazu wird je nach Multiplizität die chemische Verschiebung der Einzelsignale berechnet, indem ein definierter Frequenzwert abhängig von den gegebenen Kopplungskonstanten, von der ermittelten chemischen Verschiebung addiert oder subtrahiert wird.

In einer alternativen oder zusätzlichen Ausführungsform des Verfahrens werden die erwarteten Peak-Positionen des NMR-Signals des zu quantifizierenden Analyten, insbesondere eines Singulets und/oder Multiplets des zu quantifizierenden Analyten, aus dem 2D-NMR-Spektrum, insbesondere einem JRES-Spektrum, unter Verwendung der ermittelten chemischen Verschiebung und der zumindest einen bereitgestellten Information, insbesondere einer bereitgestellten Multiplizität auswertbarer Signale, ermittelt. Aus dem 2D-NMR-Spektrum, insbesondere aus dem JRES-Spektrum, wird durch Bestimmung der Abstände der Peakpositionen (sog. Signallagen oder Zentralfrequenzen) die Kopplungskonstanten des zu analysierenden NMR-Signals bestimmt. Je nach Multiplizität wird die chemische Verschiebung der Einzelsignale berechnet, indem ein definierter Frequenzwert, abhängig von den aus dem 2D-NMR-Spektrum, insbesondere aus dem JRES-Spektrum, bestimmten Kopplungskonstanten, von der ermittelten chemischen Verschiebung addiert oder subtrahiert wird.

In einem Verfahrensschritt werden tatsächliche Peak-Positionen aus dem bereitgestellten, insbesondere dem gemessenen, 1D-NMR-Spektrum ermittelt. Hierbei werden die Peakpositionen aller Peaks, deren Intensität im Spektrum einen gegebenen Schwellenwert überschreitet, bestimmt und in einem Zwischenspeicher hinterlegt.

In einem Verfahrensschritt werden Störsignal-Peak-Positionen unter Verwendung der erwarteten Peak-Positionen und unter Verwendung der ermittelten tatsächlichen Peak-Positionen ermittelt. In einer Ausführungsform des Verfahrens werden die Störsignal-Peak-Positionen aus einer Differenz der erwarteten Peak-Positionen und der tatsächlichen Peak-Positionen ermittelt. Unter "Störsignal-Peak-Positionen" sind insbesondere solche Peak-Positionen desjenigen Störsignals zu verstehen, das dem gesuchten Spektrum überlagert ist und welches nicht durch den zu untersuchenden Analyten hervorgerufen wird. D.h. die Störsignal-Peak-Positionen sind nicht durch den zu untersuchenden Analyten hervorgerufen worden.

In einem Verfahrensschritt wird das 1D-NMR-Spektrum unter Verwendung der ermittelten Störsignal-Peak-Positionen, unter Verwendung der ermittelten chemischen Verschiebung sowie unter Verwendung der zumindest einen bereitgestellten Information modelliert. In einer Ausführungsform des Verfahrens wird das 1D-NMR-Spektrum mittels eines Line-Fitting-Algorithmus ausgehend von den ermittelten Störsignal-Peak-Positionen und der ermittelten chemischen Verschiebung unter Optimierung von Fitparametern betreffend eine Lorenz-zu-Gauß-Verteilung, betreffend eine Linienbreite, betreffend eine Intensität, betreffend eine Kopplungskonstante sowie betreffend einen Einfluss von Dacheffekten modelliert, wobei die Störsignal-Peaks als Singulets modelliert werden.

Unter einem "Line-Fitting-Algorithmus" ist ein Algorithmus zu verstehen, bei dem ein berechnetes Signal einem gemessenen Signal durch Iterationen angepasst wird. Der Fitting-Algorithmus wird in einer Ausführungsform für einzelne Peak-Signale (beispielsweise für Resonanzlinien von Methanol) durchgeführt, kann jedoch auch auf ein gesamtes Spektrum unter gleichzeitiger Beachtung mehrerer durch den Analyten hervorgerufener Signale ausgedehnt werden.

In einem weiteren Verfahrensschritt wird das modellierte, insbesondere Störsignal-Peak-bereinigte, 1D-NMR-Spektrum, integriert.

In einem Verfahrensschritt wird der Analyt durch interne oder externe Referenzierung quantifiziert. Für die Durchführung der internen Referenzierung muss der Messprobe ein geeignetes Referenzierungsreagenz hinzugegeben werden. Typische Referenzierungsreagenzien sind beispielsweise Natriumtrimethylsilylpropionat (TSP) für wässrige Lösungen oder Tetramethylsilan (TMS) für organische Lösungen.

Eine externe Quantifizierung kann insbesondere mittels des etablierten PULCON-Verfahren durchgeführt werden. Das PULCON-Verfahren ist beispielsweise in G. Wider, L. Dreier, J. Am. Chem. Soc. 2006, No. 128, S. 2571-2576, beschrieben.

In einer Ausführungsform des Verfahrens werden die Ergebnisse der Quantifizierung mittels einer Steuervorrichtung des NMR-Messgeräts weiter verarbeitet. In einer Ausführungsform des Verfahrens kann ein Ergebnis unter Verwendung einer Ausgabevorrichtung des NMR-Messgeräts an einen Bediener des NMR-Messgeräts ausgegeben werden. In einer Ausführungsform des Verfahrens wird das Ergebnis der Quantifizierung des Analyten, insbesondere unter Verwendung der Steuervorrichtung des NMR-Messgeräts oder unter Verwendung der das Verfahren ausführenden Recheneinheit, mit einem Grenzwert verglichen und das Ergebnis des Vergleichs ausgegeben. Die Ausgabe kann dabei insbesondere mittels einer Ausgabevorrichtung des NMR-Messgeräts erfolgen.

Unter Anwendung des erfindungsgemäßen Verfahrens kann eine Vielzahl an Analyten in einer Flüssigkeit schnell, automatisch und präzise mittels NMR-Spektroskopie quantifiziert werden. Dabei erlaubt das Verfahren, spektrale NMR-Daten auf vorteilhafte Weise zu prozessieren und auszuwerten, sodass eine Quantifizierung von unterschiedlichen Analyten unter vollständiger Automatisierung der Auswertung erreichbar ist. Die Kombination der Datenprozessierung mit der Informationsintegration aus verschiedenen NMR-Datensätzen - insbesondere dem 1D-NMR-Spektrum und dem 2D-NMR-Spektrum - ermöglicht die Quantifizierung mithilfe eines zuverlässigen Line-Fitting-Optimierungsalgorithmus, sodass eine gleichbleibende Genauigkeit gewährleistet ist. Ferner ist es unter Anwendung des erfindungsgemäßen Verfahrens möglich, eine hohe Anzahl an Analyten simultan in einer Messprobe zu quantifizieren. Vorteilhaft kann als Ergebnis zu jedem zu quantifizierenden Analyten eine Konzentrationen und die jeweilige Messunsicherheit ausgegeben werden. Durch die fehlende Notwendigkeit einer geschulten Fachkraft bei der Auswertung der Messdaten kann dieses Verfahren besonders vorteilhaft in einem NMR-Messgerät implementiert werden, das zur Nutzung durch ungeschulte Benutzer konzipiert ist.

### Zeichnungen

Die Erfindung ist anhand von in den Zeichnungen dargestellten Ausführungsbeispielen in der nachfolgenden Beschreibung näher erläutert. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen. Gleiche oder ähnliche Bezugszeichen in den Figuren bezeichnen gleiche oder ähnliche Elemente.

Es zeigen:
- Figur 1: ein perspektivische Darstellung einer Ausgestaltung des erfindungsgemäßen mobilen NMR-Messgeräts,
- Figur 2: eine Draufsicht auf eine erste Gehäuseseite einer Ausgestaltung des erfindungsgemäßen NMR-Messgeräts,
- Figur 3: ein Verfahrensdiagramm einer Ausführungsform des erfindungsgemäßen Verfahrens
- Figur 4: ein exemplarisches 1D-NMR-Spektrum,
- Figur 5: ein exemplarisches 2D-NMR-Spektrum sowie einen vergrößerten Ausschnitt aus diesem 2D-NMR-Spektrums,
- Figur 6: ein exemplarisches 1D-NMR-Spektrum nach Durchführung des Verfahrensschritts der Ermittlung der tatsächlichen Peak-Positionen,
- Figur 7: ein exemplarisches 1D-NMR-Spektrum nach Durchführung des Verfahrensschritts des Line-Fittings.

### Beschreibung der Ausführungsbeispiele

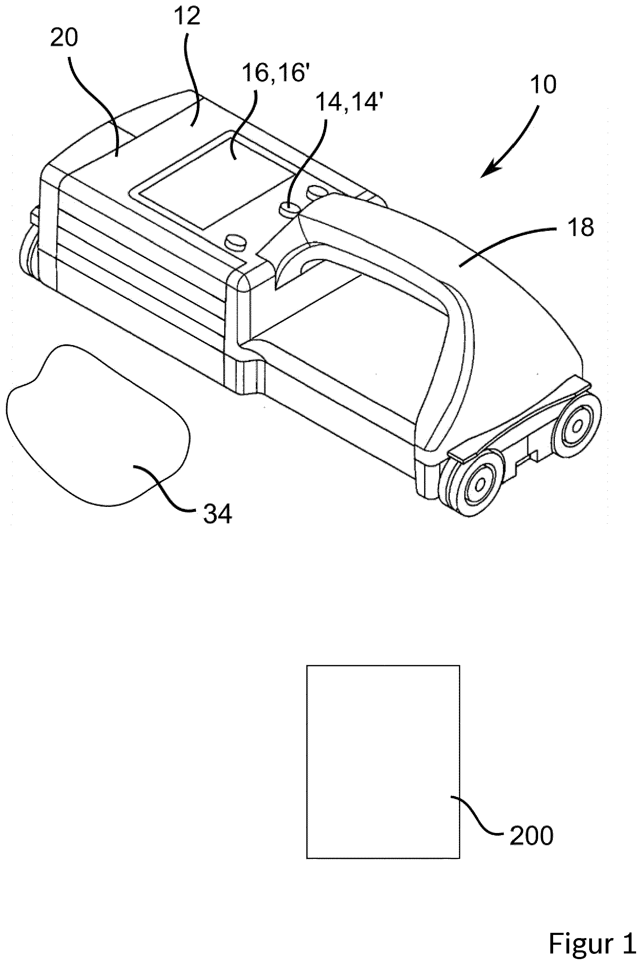

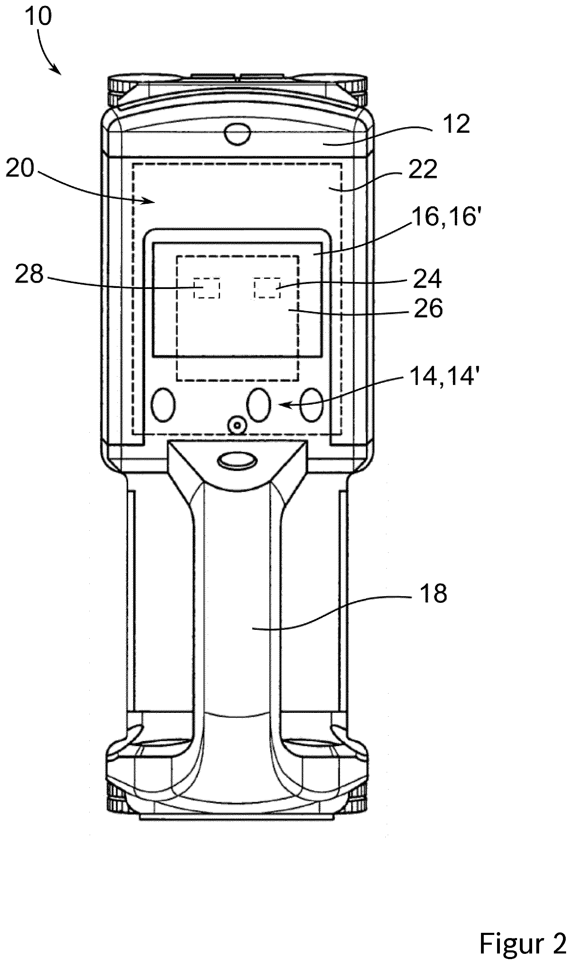

Figur 1 und Figur 2 zeigen zwei Ansichten einer beispielhaften Ausführungsform des erfindungsgemäßen handgehaltenen, energieautonomen NMR-Messgeräts 10 in perspektivischer Darstellung bzw. in vereinfachter, schematischer Aufsicht.

Das beispielhaft ausgeführte NMR-Messgerät 10 weist ein Gehäuse 12 auf. In dem Gehäuse 12 ist eine Eingabevorrichtung 14 in Form von Betätigungselementen 14', geeignet zum Ein- und Ausschalten des NMR-Messgeräts 10, zum Starten und Konfigurieren eines Messvorgangs und zum Eingeben von Arbeitsparametern, untergebracht. Ferner ist in dem Gehäuse 12 eine Ausgabevorrichtung 16 zur Ausgabe von ermittelten Informationen sowie zur Ausgabe von Arbeitsparametern in Form eines Bildschirm 16' vorgesehen. Das NMR-Messgerät 10 verfügt zum Transport und zu dessen Führung über einen Handgriff 18. Der Handgriff 18, die Betätigungselemente 14' sowie der Bildschirm 16' befinden sich auf einer ersten Gehäuseseite 20 des NMR-Messgeräts 10 (auch "Frontseite"), die bei einer Bedienung des NMR-Messgeräts typischerweise dem Bediener zugewandt ist.

Zur Energieversorgung des NMR-Messgerät 10 weist das NMR-Messgerät 10 auf der, der ersten Gehäuseseite 20 geräterückseitig gegenüberliegenden, zweiten Gehäuseseite (hier nicht näher dargestellt) eine Aussparung auf, die der Aufnahme von stromnetzunabhängigen Energiespeichern (hier nicht näher dargestellt) in Form von wiederaufladbaren Akkus dient. Auf Grund des stromnetzunabhängigen Energiespeichers kann das NMR-Messgerät 10 zumindest vorübergehend energieautonom, d.h. unabhängig von einem Stromnetz und somit insbesondere auch kabellos, betrieben werden. Das beispielhaft vorgestellte NMR-Messgerät 10 besitzt Lithium-Ionen-Akkus, deren hohe Energie- und Leistungsdichte vorteilhaft zur Energieversorgung des NMR-Messgeräts 10 geeignet ist. In einer alternativen Ausführungsform kann der Energiespeicher auch im Handgriff 18 des NMR-Messgeräts 10 untergebracht sein. Vorzugsweise weist die Energieversorgungsvorrichtung eine lösbare Formschluss- und/oder Kraftschlussverbindungsschnittstelle auf, sodass der Energiespeicher (im Allgemeinen auch mehrere) abnehmbar und austauschbar anordenbar ist. Darüber hinaus lässt sich der Energiespeicher in und/oder außerhalb des NMR-Messgeräts 10 mit Energie aus einem Stromnetz versorgen und laden.

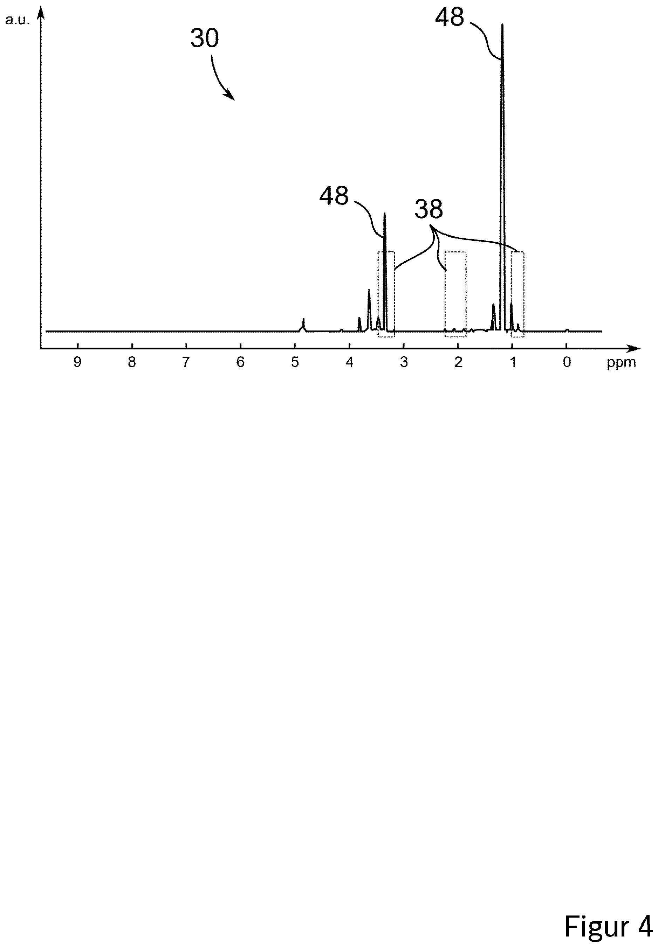

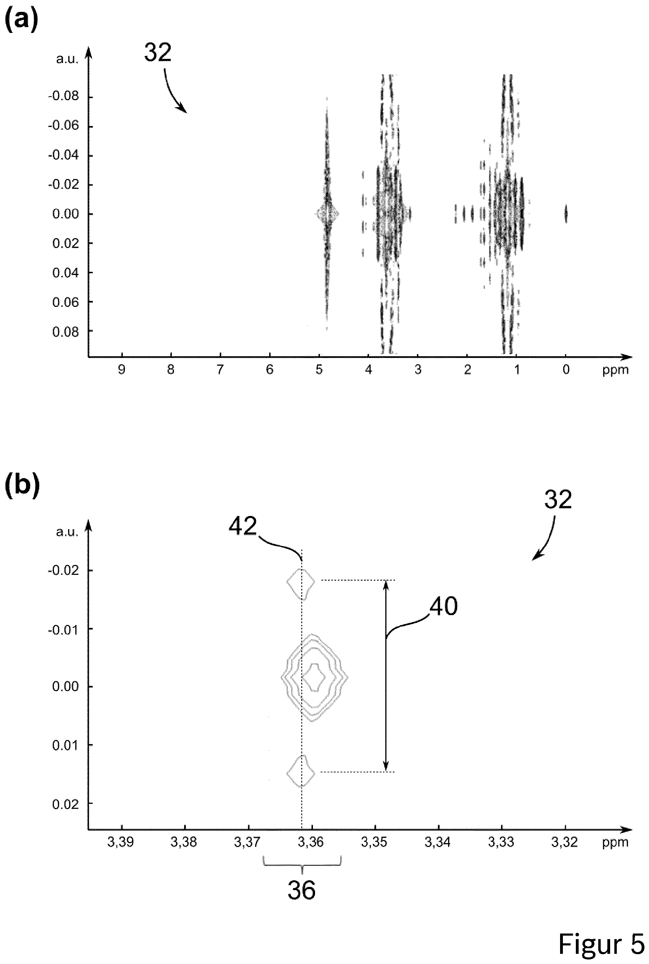

Auf einem Trägerelement 22, insbesondere einer Systemplatine oder Leiterplatte innerhalb des Gehäuses 12, sind weitere Komponenten des NMR-Messgeräts 10, insbesondere ein NMR-Sensor 24, eine Steuervorrichtung 26 zur Steuerung des NMR-Messgeräts 10 und zur Auswertung von von dem NMR-Sensor 24 gelieferten Messsignalen, sowie eine mit der Steuervorrichtung 26 verbundene Datenkommunikationsschnittstelle 28, untergebracht (siehe insbesondere Figur 2). Die Steuervorrichtung 26 dient zur Auswertung zumindest eines von dem NMR-Sensor gelieferten Messsignals, insbesondere eines gemessenen 1D-NMR-Spektrums 30 (vgl. Figur 4) und eines gemessenen 2D-NMR-Spektrums 32 (vgl. Figur 5), insbesondere eines JRES-, HMBC-, HSQC-, COSY- und/oder DOSY-Spektrums. Alternativ oder zusätzlich kann das Messsignal, insbesondere ein 1D-NMR-Spektrum 30 und ein 2D-NMR-Spektrum 32, insbesondere ein JRES-, HMBC-, HSQC-, COSY- und/oder DOSY-Spektrum, auch anderweitig der Steuervorrichtung 26 bereitgestellt werden, beispielsweis unter Verwendung der Datenkommunikationsschnittstelle 28 des NMR-Messgeräts 10. Die Steuervorrichtung 26 weist eine Steuerelektronik umfassend Mittel zur Kommunikation mit den anderen Komponenten des NMR-Messgeräts 10 auf, beispielsweise Mittel zur Steuerung und Regelung des NMR-Sensors 24, einer von der Steuervorrichtung 26 unabhängigen Auswertevorrichtung oder dergleichen. Die Steuervorrichtung 26 umfasst insbesondere eine Einheit mit einer Prozessoreinheit, einer Speichereinheit und einem in der Speichereinheit gespeicherten Betriebsprogramm. Die Steuervorrichtung 26 ist dazu vorgesehen, zumindest ein Betriebsfunktionsparameter des NMR-Messgeräts 10 in Abhängigkeit von zumindest einer Eingabe durch den Bediener, durch eine ggf. vorgesehene Auswertevorrichtung und/oder durch die Datenkommunikationsschnittstelle 28 einzustellen. Ferner ist die Steuervorrichtung 26 zur Durchführung des erfindungsgemäßen Verfahrens vorgesehen und weist dazu einen Speicher mit einem darauf gespeicherten und ausführbaren Betriebsprogramm auf.

Der NMR-Sensor 24 ist zur Anregung einer Kernspinresonanz in Atomkernen des Materials einer Messprobe 34 vorgesehen. Der NMR-Sensor 24 ist insbesondere zum Messen eines 1D-NMR-Spektrums 30 und eines 2D-NMR-Spektrums 32, insbesondere eines JRES-, HMBC-, HSQC-, COSY- und/oder DOSY-Spektrums, der Messprobe 34 vorgesehen.

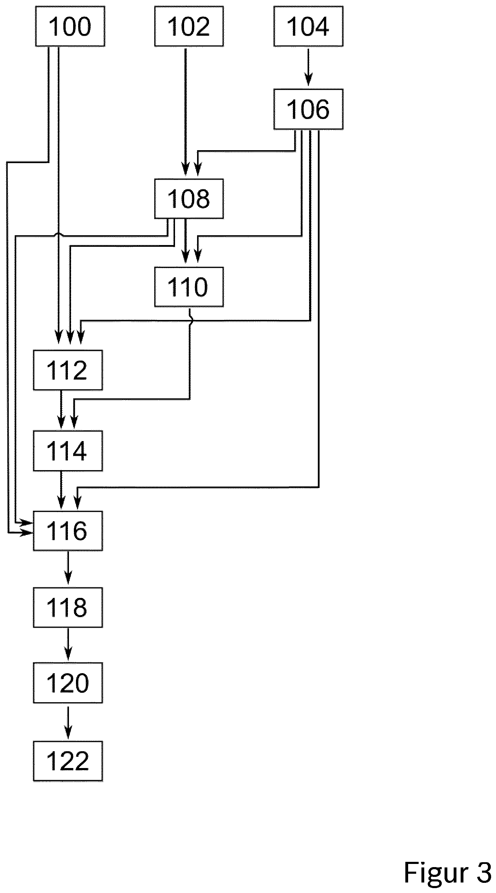

In der Figur 3 ist ein Verfahrensdiagramm gezeigt, dass ein Ausführungsbeispiel des erfindungsgemäßen Verfahrens zur Quantifizierung eines Analyten in einer Messprobe 34, insbesondere in einer flüssigen Messprobe, insbesondere mittels des NMR-Messgeräts 10, darstellt.

In Verfahrensschritt 100 wird ein mittels des NMR-Sensors 24 des NMR-Messgeräts 10 gemessenes 1D-NMR-Spektrums 30 bereitgestellt. Dieses 1D-NMR-Spektrum 30, insbesondere die zu Grunde liegenden Daten, sind bereits in Verfahrensschritt 100 zur Auswertung vorbereitet worden, beispielsweise durch Glätten, Filtern oder dergleichen. Ein beispielhaftes 1D-NMR-Spektrum 30 ist in Figur 4 dargestellt. Das 1D-NMR-Spektrum 30 weist für die Messprobe 34, insbesondere den darin enthaltenen Analyten, charakteristische Peaks 48 auf.

In Verfahrensschritt 102 wird ein mittels des NMR-Sensors 24 des NMR-Messgeräts gemessenes 2D-NMR-Spektrum 32, insbesondere eines JRES-, HMBC-, HSQC-, COSY- und/oder DOSY-Spektrums, bereitgestellt. Auch dieses 2D-NMR-Spektrum 32, insbesondere die zu Grunde liegenden Daten, sind bereits in Verfahrensschritt 102 zur Auswertung vorbereitet worden, beispielsweise durch Glätten, Filtern oder dergleichen. Ein beispielhaftes 2D-NMR-Spektrum 32, insbesondere ein JRES-Spektrum, ist in Figur 5a dargestellt.

In Verfahrensschritt 104 wird der zumindest eine zu quantifizierenden Analyt spezifiziert, beispielsweise in Folge einer Eingabe oder Auswahl durch einen Benutzer, beispielsweise mittels einer Eingabevorrichtung 14 des NMR-Messgeräts 10. In diesem Ausführungsbeispiel gibt der Benutzer den zu quantifizierenden Analyten explizit an, indem er beispielsweise den Namen des Analyten "Alkohol" (beispielsweise aus einer vorgegebenen Liste) auswählt.

In Verfahrensschritt 106 wird - ausgehend von dem spezifizierten Namen des Analyten - eine Information zu dem zu quantifizierenden Analyten bereitgestellt. Die Information spezifiziert dabei zumindest einen chemischen Verschiebungsbereich 36 (grober Bereich der erwarteten chemischen Verschiebung 42; in Figur 5 dargestellt durch den Bereich 36), eine Anzahl auswertbarer Signale 38 (in Figur 4 durch jeweils einen Kasten dargestellt), eine Multiplizität auswertbarer Signale und eine Kopplungskonstante auswertbarer Signale zu dem zu quantifizierenden Analyten. Die Multiplizität auswertbarer Signale und die Kopplungskonstante auswertbarer Signale sind in Figur 5b, die einen vergrößerten Bereich des in Figur 5a dargestellten 2D-NMR-Spektrums 32 darstellt, als Bezugszeichen 40 zusammengefasst. In dem in Figur 5b dargestellten Beispiel beträgt die Multiplizität 2 (Duplet), die Kopplungskonstante ca. 6,4 Hz (entspricht dem Abstand zwischen beiden Peaks, bezeichnet mit Bezugszeichen 40). Die Information zu dem zumindest einen zu quantifizierenden Analyten wird in diesem Ausführungsbeispiel durch eine Datenbankabfrage, insbesondere unter Verwendung einer Internetverbindung, bereitgestellt. Die von einer Datenbank 200 (vgl. Figur 1) mittels der Datenkommunikationsschnittstelle 28 des NMR-Messgeräts 10 abgerufenen Daten werden an die Steuervorrichtung 26 weitergeleitet.

In Verfahrensschritt 108 wird eine chemische Verschiebung 42 des NMR-Signals des zu quantifizierenden Analyten aus dem 2D-NMR-Spektrum 32 unter Verwendung der zumindest einen bereitgestellten Information ermittelt. Unter Verwendung des chemischen Verschiebungsbereichs 36 des Analyten wird in dem Datensatz des 2D-NMR-Spektrums 32 zunächst ein reales Signal mit passenden Parametern gesucht und daraus die "tatsächliche" chemische Verschiebung 42 ermittelt. Ist kein entsprechendes, d.h. unter Verwendung des chemischen Verschiebungsbereichs 36 auswertbares Signal in dem Datensatz ermittelbar, kann eine erneute Abfrage weiterer Informationen aus der Datenbank 200 initiiert werden. Alternativ kann eine Fehlermeldung oder ein Hinweis, dass eine Auswertung nicht erfolgreich durchgeführt werden konnte, an den Benutzer des NMR-Messgeräts 10 ausgegeben werden.

In Verfahrensschritt 110 werden erwartete Peak-Positionen (hier nicht näher dargestellt) des NMR-Signals des zu quantifizierenden Analyten, insbesondere eines Singulets und/oder Multiplets des zu quantifizierenden Analyten, ermittelt. Die erwarteten Peak-Positionen des NMR-Signals werden in diesem Ausführungsbeispiel unter Verwendung der ermittelten (d.h. der tatsächlichen) chemischen Verschiebung 42 und der zumindest einen bereitgestellten Information, insbesondere der bereitgestellten Multiplizität auswertbarer Signale und der bereitgestellten Kopplungskonstante auswertbarer Signale (Bezugszeichen 40), berechnet. Zusätzlich können die erwarteten Peak-Positionen des NMR-Signals auch aus dem 2D-NMR-Spektrum 32, insbesondere einem JRES-Spektrum, unter Verwendung der ermittelten (tatsächlichen) chemischen Verschiebung 42 und der zumindest einen bereitgestellten Information, insbesondere einer bereitgestellten Multiplizität auswertbarer Signale (40), ermittelt werden (hier nicht näher dargestellt).

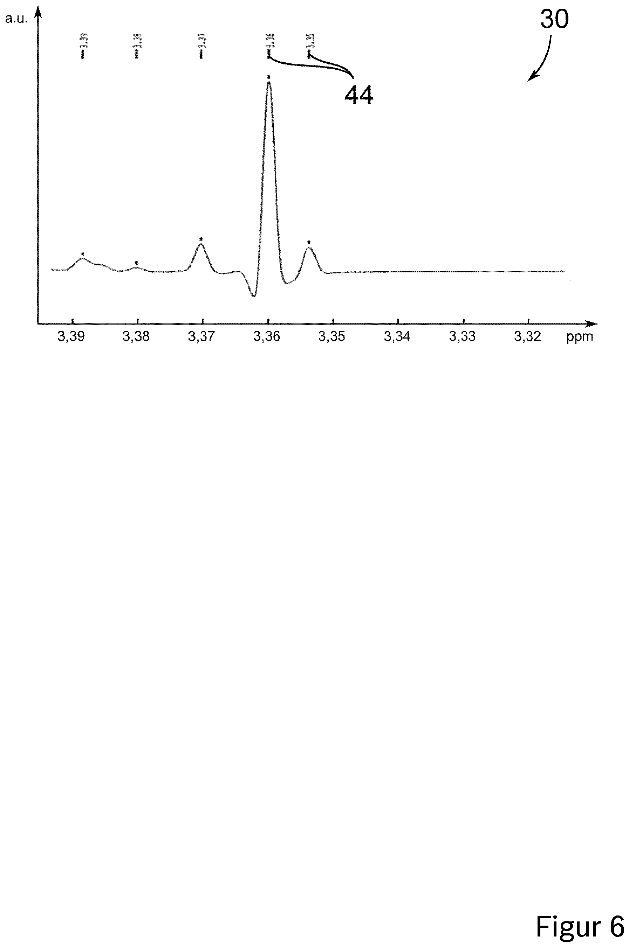

In Verfahrensschritt 112 werden tatsächliche Peak-Positionen 44 aus dem 1D-NMR-Spektrum 30 ermittelt. Dazu wird das 1D-NMR-Spektrum 30 beispielsweise auf lokale Maxima analysiert. In Figur 6 ist ein beispielhaftes 1D-NMR-Spektrum dargestellt, in dem die tatsächlichen Peak-Positionen 44 markiert und mit Werten belegt dargestellt sind.

In Verfahrensschritt 114 werden Störsignal-Peak-Positionen unter Verwendung der erwarteten Peak-Positionen und der tatsächlichen Peak-Positionen 44 aus der Differenz der erwarteten Peak-Positionen und der tatsächlichen Peak-Positionen 44 ermittelt (nicht näher dargestellt).

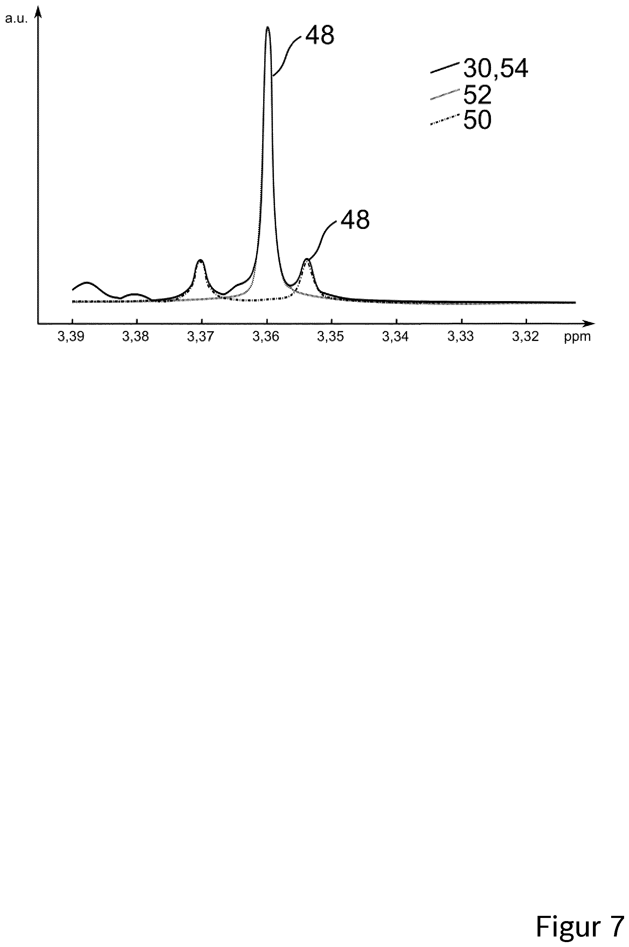

In Verfahrensschritt 116 wird anschließend das 1D-NMR-Spektrum 30 unter Verwendung der ermittelten Störsignal-Peak-Positionen, unter Verwendung der ermittelten chemischen Verschiebung 42 sowie unter Verwendung der zumindest einen bereitgestellten Information modelliert. Die Modellierung erfolgt dabei mittels eines Line-Fitting-Algorithmus ausgehend von den ermittelten Störsignal-Peak-Positionen und der ermittelten chemischen Verschiebung 42 unter Optimierung von Fitparametern betreffend eine Lorenz-zu-Gauß-Verteilung, betreffend eine Linienbreite, betreffend eine Intensität, betreffend eine Kopplungskonstante sowie betreffend einen Einfluss von Dacheffekten, wobei die Störsignal-Peaks als Singulets 52 modelliert werden. Auf diese Weise wird ein reines, insbesondere Störsignal-Peak-bereinigtes, modelliertes 1D-NMR-Spektrum 50 erzeugt. Figur 7 zeigt diesbezüglich beispielhaft einen Ausschnitt eines 1D-NMR-Spektrums 30 nach/während Durchführung des Verfahrensschritts 116. In dem exemplarischen Datensatz findet sich ein Duplet von Isobutanol (Bezugszeichen 50) - das zu quantifizierende NMR-Signal des gewünschten Analyten - überlagert mit einem Störsignal 52 von Methanol (Singulet). Das bereitgestellte 1D-NMR-Spektrum 30 wird nach Durchführung des Line-Fitting-Algorithmus durch die Kurve 54, die das modellierte 1D-NMR-Spektrums 54 darstellt, wiedergegeben. Das gesuchte, zu quantifizierende NMR-Signal des Analyten wird durch das Störsignal-Peak-bereinigte modelliertes 1D-NMR-Spektrum 50 wiedergegeben.

In Verfahrensschritt 118 wird das modellierte, insbesondere Störsignal-Peak-bereinigte, 1D-NMR-Spektrum 50 integriert.

In Verfahrensschritt 120 wird der Analyt durch interne oder externe Referenzierung quantifiziert. Ist mehr als ein Signal pro Analyt vorhanden, kann abschließend ein Mittelwert des Quantifizierungswerts berechnet werden (nicht näher dargestellt).

In Verfahrensschritt 122 werden die Ergebnisse der Quantifizierung mittels der Steuervorrichtung 26 des NMR-Messgeräts 10 weiter verarbeitet, insbesondere mittels der Ausgabevorrichtung 16 des NMR-Messgeräts 10 an einen Bediener des NMR-Messgeräts 10 ausgegeben. In dieser Ausführungsform wird ein Prozentwert ausgegeben, der die Konzentration des Analyten in der Messprobe 34 angibt. Ferner wird das Ergebnis der Quantifizierung des Analyten mit einem Grenzwert verglichen und das Ergebnis des Vergleichs mit einer farbigen LED (rot, gelb, grün) ausgegeben (nicht näher dargestellt).

## Patentansprüche

1. Verfahren zum automatisierten Quantifizieren eines Analyten in einer Messprobe (34), insbesondere in einer flüssigen Messprobe, umfassend die Verfahrensschritte
• Spezifizieren eines zu quantifizierenden Analyten;
• Bereitstellen (100) eines 1D-NMR-Spektrums (30);
• Bereitstellen (102) eines 2D-NMR-Spektrums (32), insbesondere eines JRES-, HMBC-, HSQC-, COSY- und/oder DOSY-Spektrums;
• Bereitstellen (106) einer Information zu einem zu quantifizierenden Analyten;
• Ermitteln (108) einer chemischen Verschiebung (42) eines NMR-Signals des zu quantifizierenden Analyten aus dem 2D-NMR-Spektrum (32) unter Verwendung der einen bereitgestellten Information;
• Ermitteln (110) von erwarteten Peak-Positionen des NMR-Signals des zu quantifizierenden Analyten, insbesondere eines Singulets und/oder Multiplets des zu quantifizierenden Analyten;
• Ermitteln (112) von tatsächlichen Peak-Positionen (44) aus dem 1D-NMR-Spektrum (30);
• Ermitteln (114) von Störsignal-Peak-Positionen unter Verwendung der erwarteten Peak-Positionen und der tatsächlichen Peak-Positionen (44);
• Modellieren (116) des 1D-NMR-Spektrums (30) unter Verwendung der ermittelten Störsignal-Peak-Positionen, unter Verwendung der ermittelten chemischen Verschiebung (42) sowie unter Verwendung der einen bereitgestellten Information;
• Integration (118) des modellierten 1D-NMR-Spektrums (50);
• Quantifizieren (120) Analyten durch interne oder externe Referenzierung.

2. Verfahren nach Anspruch 1, **dadurch gekenn-zeichnet, dass** die Information zu dem zu quantifizierenden Analyten durch eine Datenbankabfrage bereitgestellt wird.

3. Verfahren nach einem der vorhergehenden Ansprüche, **dadurch gekennzeichnet, dass** die bereitgestellte Information einen chemischen Verschiebungsbereich, eine Anzahl auswertbarer Signale, eine Multiplizität auswertbarer Signale und/oder eine Kopplungskonstante auswertbarer Signale zu dem zu quantifizierenden Analyten spezifiziert.

4. Verfahren nach einem der vorhergehenden Ansprüche, **dadurch gekennzeichnet, dass** die erwarteten Peak-Positionen des NMR-Signals des zu quantifizierenden Analyten, insbesondere eines Singulets und/oder Multiplets des zu quantifizierenden Analyten, unter Verwendung der ermittelten chemischen Verschiebung (42) und der bereitgestellten Information, insbesondere einer bereitgestellten Multiplizität auswertbarer Signale und einer bereitgestellten Kopplungskonstante auswertbarer Signale, berechnet wird.

5. Verfahren nach einem der vorhergehenden Ansprüche, **dadurch gekennzeichnet, dass** die erwarteten Peak-Positionen des NMR-Signals des zu quantifizierenden Analyten, insbesondere eines Singulets und/oder Multiplets des zu quantifizierenden Analyten, aus dem 2D-NMR-Spektrum (32), insbesondere einem JRES-Spektrum, unter Verwendung der ermittelten chemischen Verschiebung (42) und der bereitgestellten Information, insbesondere einer bereitgestellten Multiplizität auswertbarer Signale, ermittelt wird.

6. Verfahren nach einem der vorhergehenden Ansprüche, **dadurch gekennzeichnet, dass** die Störsignal-Peak-Positionen aus einer Differenz der erwarteten Peak-Positionen und der tatsächlichen Peak-Positionen (44) ermittelt wird.

7. Verfahren nach einem der vorhergehenden Ansprüche, **dadurch gekennzeichnet, dass** das 1D-NMR-Spektrum (30) mittels eines Line-Fitting-Al-gorithmus ausgehend von den ermittelten Störsignal-Peak-Positionen und der ermittelten chemischen Verschiebung (42) unter Optimierung von Fitparametern betreffend eine Lorentz-zu-Gauß-Verteilung, betreffend eine Linienbreite, betreffend eine Intensität, betreffend eine Kopplungskonstante sowie betreffend einen Einfluss von Dacheffekten modelliert wird, wobei die Störsignal-Peaks als Singulets (52) modelliert werden.

8. Verfahren nach einem der vorhergehenden Ansprüche, **dadurch gekennzeichnet, dass** das Ergebnis der Quantifizierung des Analyten mit einem Grenzwert verglichen wird und das Ergebnis des Vergleichs ausgegeben wird.

9. NMR-Messgerät (10), insbesondere handgehaltenes NMR-Messgerät, mit einem NMR-Sensor (24), einer Steuervorrichtung (26) zur Steuerung des NMR-Messgeräts (10) und zur Auswertung eines von dem NMR-Sensors (24) gelieferten Messsignals, eine Ausgabevorrichtung (16,16') zur Ausgabe von ermittelten Informationen sowie mit einer Energieversorgungsvorrichtung, insbesondere einer Batterie, **dadurch gekennzeichnet, dass** das NMR-Messgerät (10) zur Durchführung des Verfahrens nach einem der Ansprüche 1-8 eingerichtet ist.

## Claims

1. Method for the automated quantification of an analyte in a test sample (34), particularly in a liquid test sample, comprising the following method steps
• specifying an analyte to be quantified;
• supplying (100) a 1D-NMR spectrum (30);
• supplying (102) a 2D-NMR spectrum (32), in particular a JRES, HMBC, HSQC, COSY, and/or DOSY spectrum;
• supplying (106) a piece of information about an analyte to be quantified;
• determining (108) a chemical shift (42) of an NMR signal of the analyte to be quantified from the 2D-NMR spectrum (32) on the basis of the supplied piece of information;
• determining (110) the expected peak positions of the NMR signal of the analyte to be quantified, in particular of a singlet and/or multiplet of the analyte to be quantified;
• determining (112) the actual peak positions (44) from the 1D-NMR spectrum (30);
• determining (114) the peak positions of interfering signals on the basis of the expected peak positions and actual peak positions (44);
• modelling (116) the 1D-NMR spectrum (30) on the basis of the peak positions determined for interfering signals, on the basis of the determined chemical shift (42), and on the basis of the supplied piece of information;
• integrating (118) the modelled 1D-NMR spectrum (50);
• quantifying (120) the analyte through internal or external referencing.

2. Method according to Claim 1, **characterized in that** the piece of information about an analyte to be quantified is supplied by a database query.

3. Method according to any of the preceding claims, **characterized in that** the supplied piece of information specifies a chemical shift range, a number of evaluable signals, a multiplicity of evaluable signals and/or a coupling constant of evaluable signals for the analyte to be quantified.

4. Method according to any of the preceding claims, **characterized in that** the expected peak positions of the NMR signal of the analyte to be quantified, in particular of a singlet and/or multiplet of the analyte to be quantified, are calculated on the basis of the determined chemical shift (42) and of the supplied piece of information, in particular a supplied multiplicity of evaluable signals and a supplied coupling constant of evaluable signals.

5. Method according to any of the preceding claims, **characterized in that** the expected peak positions of the NMR signal of the analyte to be quantified, in particular of a singlet and/or multiplet of the analyte to be quantified, are determined from the 2D-NMR spectrum (32), in particular from a JRES spectrum, on the basis of the determined chemical shift (42) and the supplied piece of information, in particular a supplied multiplicity of evaluable signals.

6. Method according to any of the preceding claims, **characterized in that** the peak positions of interfering signals are determined from a difference of the expected peak positions and actual peak positions (44).

7. Method according to any of the preceding claims, **characterized in that** the 1D-NMR spectrum (30) is modelled by means of a line-fitting algorithm based on the determined peak positions of interfering signals and the determined chemical shift (42) by optimization of fit parameters for a Lorentzian to Gaussian distribution, for line width, for intensity, for a coupling constant, and for an influence of roof effects, wherein the peaks for interfering signals are modelled as singlets (52) .

8. Method according to any of the preceding claims, **characterized in that** the result of the quantification of the analyte is compared with a threshold value and the result of the comparison is displayed.

9. NMR instrument (10), in particular a handheld NMR instrument, having an NMR sensor (24), a control device (26) for controlling the NMR instrument (10) and for evaluating a measurement signal delivered by the NMR sensor (24), a display device (16,16') for displaying the information determined, and a power supply device, in particular a battery, **characterized in that** the NMR instrument (10) is configured for carrying out the method according to any of Claims 1-8.

## Revendications

1. Procédé de quantification automatisée d'un analyte dans un échantillon (34), en particulier dans un échantillon liquide, comprenant les étapes de procédé consistant à
• spécifier un analyte à quantifier ;
• fournir (100) un spectre RMN 1D (30) ;
• prévoir (102) un spectre RMN 2D (32), en particulier un spectre JRES, HMBC, HSQC, COSY et/ou DOSY ;
• fournir (106) une information concernant un analyte à quantifier ;
• déterminer (108) un décalage chimique (42) d'un signal RMN de l'analyte à quantifier à partir du spectre RMN 2D (32) en utilisant ladite une information fournie ;
• déterminer (110) des positions de pic attendues du signal RMN de l'analyte à quantifier, en particulier d'un singulet et/ou d'un multiplet de l'analyte à quantifier ;
• déterminer (112) des positions de pic réelles (44) à partir du spectre RMN 1D (30) ;
• déterminer (114) des positions de pic de signal parasite en utilisant les positions de pic attendues et les positions de pic réelles (44) ;
• modéliser (116) le spectre RMN 1D (30) en utilisant les positions de pic de signal parasite déterminées, en utilisant le décalage chimique déterminé (42), ainsi qu'en utilisant ladite information fournie ;
• intégrer (118) le spectre RMN 1D (50) modélisé ;
• quantifier (120) l'analyte par référencement interne ou externe.

2. Procédé selon la revendication 1, **caractérisé en ce que** l'information concernant l'analyte à quantifier est fournie par une consultation de base de données.

3. Procédé selon l'une quelconque des revendications précédentes, **caractérisé en ce que** l'information fournie spécifie une plage de décalage chimique, un nombre de signaux pouvant être évalués, une multiplicité de signaux pouvant être évalués et/ou une constante de couplage de signaux pouvant être évalués pour l'analyte à quantifier.

4. Procédé selon l'une quelconque des revendications précédentes, **caractérisé en ce que** les positions de pic attendues du signal RMN de l'analyte à quantifier, en particulier d'un singulet et/ou d'un multiplet de l'analyte à quantifier, sont calculées en utilisant le décalage chimique déterminé (42) et l'information fournie, en particulier une multiplicité fournie de signaux pouvant être évalués et une constante de couplage fournie de signaux pouvant être évalués.

5. Procédé selon l'une quelconque des revendications précédentes, **caractérisé en ce que** les positions de pic attendues du signal RMN de l'analyte à quantifier, en particulier d'un singulet et/ou d'un multiplet de l'analyte à quantifier, sont déterminées à partir du spectre RMN 2D (32), en particulier d'un spectre JRES, en utilisant le décalage chimique déterminé (42) et l'information fournie, en particulier une multiplicité fournie de signaux pouvant être évalués.

6. Procédé selon l'une quelconque des revendications précédentes, **caractérisé en ce que** les positions de pic de signal parasite sont déterminées à partir d'une différence des positions de pic attendues et des positions de pic réelles (44).

7. Procédé selon l'une quelconque des revendications précédentes, **caractérisé en ce que** le spectre RMN 1D (30) est modélisé au moyen d'un algorithme d'ajustement de ligne en partant des positions de pic de signal parasite déterminées et du décalage chimique déterminé (42) en optimisant des paramètres d'ajustement concernant une distribution de Lorentz-Gauss, concernant une largeur de ligne, concernant une intensité, concernant une constante de couplage, ainsi que concernant une influence d'effets de toit, les pics de signal parasite étant modélisés sous forme de singulets (52).

8. Procédé selon l'une quelconque des revendications précédentes, **caractérisé en ce que** le résultat de la quantification de l'analyte est comparé avec une valeur limite, et le résultat de la comparaison est sorti.

9. Appareil de mesure RMN (10), en particulier appareil de mesure RMN manuel, comprenant un capteur RMN (24), un dispositif de commande (26) pour commander l'appareil de mesure RMN (10) et pour évaluer un signal de mesure fourni par le capteur RMN (24), un dispositif de sortie (16, 16') pour sortir des informations déterminées, ainsi qu'un dispositif d'alimentation en énergie, en particulier une batterie,
**caractérisé en ce que** l'appareil de mesure RMN (10) est conçu pour exécuter le procédé selon l'une quelconque des revendications 1 à 8.
